Europäisches Patentamt

European Patent Office

Office européen des brevets

(19)

(11) Numéro de publication: **0 153 774 B1**

# FASCICULE DE BREVET EUROPEEN

(12)

(45) Date de publication de fascicule du brevet:
**21.11.91**

(51) Int. Cl.⁵: **H03K 19/094**

(21) Numéro de dépôt: **85200131.2**

(22) Date de dépôt: **07.02.85**

Le dossier contient des informations techniques
présentées postérieurement au dépôt de la
demande et ne figurant pas dans le présent
fascicule.

(54) **Circuit logique élémentaire réalisé à l'aide de transistors à effet de champ en arséniure de gallium et compatible avec la technologie ECL 100 K.**

(30) Priorité: **08.02.84 FR 8401932**

(43) Date de publication de la demande:
**04.09.85 Bulletin 85/36**

(45) Mention de la délivrance du brevet:
**21.11.91 Bulletin 91/47**

(84) Etats contractants désignés:
**DE FR GB IT NL**

(56) Documents cités:
**EP-A- 0 085 569
FR-A- 2 099 227
US-A- 4 410 815**

**Katsushiko Suyama et al. de Fujitsu Ltd.:"A GaAs high-speed counter using current mode logic",MCS 83 (Microwave and Millimeterwave Monolithic Circuit Symposium, IEEE 1983)**

(73) Titulaire: **LABORATOIRES D'ELECTRONIQUE PHILIPS
3, Avenue Descartes
F-94450 Limeil-Brévannes(FR)**

(84) Etats contractants désignés:
**FR**

Titulaire: **N.V. Philips' Gloeilampenfabrieken
Groenewoudseweg 1
NL-5621 BA Eindhoven(NL)**

(84) Etats contractants désignés:
**DE GB IT NL**

(72) Inventeur: **Chantepie, Bernard
Société Civile S.P.I.D. 209 rue de l'Université
F-75007 Paris(FR)**

(74) Mandataire: **Landousy, Christian et al
Société Civile S.P.I.D. 156, Boulevard Haus-smann
F-75008 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

Rank Xerox (UK) Business Services

EP 0 153 774 B1

## Description

L'invention concerne un circuit logique réalisé avec des transistors unipolaires en arséniure de gallium (GaAs), comprenant un amplificateur différentiel et des étages translateurs de niveau appliqués respectivement aux sorties $S_1$ et $S_2$ de la première et de la seconde branches de l'amplificateur différentiel, étages translateurs fournissant les sorties S et $\bar{S}$ du circuit logique.

L'invention trouve son application dans la réalisation de modules de circuits intégrés ultrarapides à faible consommation en arséniure de gallium compatibles avec les circuits intégrés ultrarapides réalisés en logique ECL 100 K sur silicium.

La technologie ECL 100 K (de l'anglais : Emitter Coupled Logic), utilisant des transistors bipolaires, permet de réaliser des circuits intégrés ultrarapides. Mais de tels circuits consomment beaucoup d'énergie. C'est pourquoi les efforts actuels de la recherche portent sur le remplacement, dans certains cas, de la technologie ECL 100 K par une autre technologie permettant de réaliser des circuits intégrés aussi rapides mais consommant beaucoup moins d'énergie.

Cependant le remplacement d'une famille logique par une autre famille logique ne peut être opéré que graduellement. Il est donc nécessaire, dans un premier temps, de prévoir le remplacement d'un certain nombre de modules réalisés en technologie ECL 100 K par des modules équivalents réalisés dans la nouvelle technologie étudiée à cet effet. Les deux technologies doivent alors coexister et il est impératif de les rendre compatibles. Dans ces conditions, elles doivent présenter :
- la même ou les mêmes tensions d'alimentation ;
- le même niveau de tension de commande des portes logiques ;
- le même gabarit de fonction de transfert des portes logiques ;

Remplacer un module entier de circuit intégré réalisé en technologie ECL 100 K conduit donc d'abord à étudier la possibilité de remplacer une porte élémentaire ECL 100 K par une porte équivalente réalisée dans la nouvelle technologie.

Une porte élémentaire dans la technologie ECL est connue par le FR-A-2407612, dans laquelle une telle porte est représentée comme une partie de la figure 1 et donnée comme une porte logique ≪OU/NON-OU≫. Il faut noter qu'il s'agit en fait d'une porte ≪NON-OU≫ à une seule entrée, plutôt à fonction ≪INVERSEUR≫, mais capable de sortir deux signaux complémentaires. Cette porte est constituée d'abord, par un amplificateur différentiel, réalisé par deux transitors planar n-p-n $T_1$ et $T_2$ à émetteurs couplés et dont la sortie est reliée par l'intermédiaire d'une résistance $R_1$ ou $R_2$ à un potentiel de référence $V_{CC}$, notamment la masse. La base du transistor $T_1$ reçoit le signal d'entrée $I_1$, tandis que la base du transistor $T_1$ est raccordée à un potentiel de référence $V_{BB}$, qui est une référence interne. Pour réaliser l'alimentation en courant de cet étage différentiel, on utilise un transistor $S_1$ dont la base est portée à un potentiel $V_B$ et dont l'émetteur est raccordé à travers une résistance $R_1$ à un troisième potentiel désigné par $V_{EE}$. La sortie de l'étage différentiel formée par le collecteur du transistor $T_2$ est raccordée à la base d'un autre transistor bipolaire $T_3$ tandis que la sortie formée par le collecteur du transistor $T_1$ est reliée à la base d'un autre transistor bipolaire $T_4$. Les collecteurs des deux transistors $T_3$, $T_4$ sont placés au potentiel d'alimentation $V_{CC}$, tandis que leurs émetteurs sont respectivement alimentés en courant par un transistor S, dont le montage est analogue à celui du transistor $S_1$. La sortie du signal vrai se fait sur l'émetteur du transistor $T_3$, alors que la sortie de son complémentaire se fait sur l'émetteur du transistor $T_4$.

Les performances obtenues à l'aide d'une telle logique sont, par porte élémentaire, une puissance consommée de l'ordre de 20 mW, un temps de propagation de l'ordre de 400 ps, une fréquence de travail maximale de l'ordre de 1 GHz. La densité d'intégration peut atteindre 1200 à 2000 portes au $cm^2$.

Or les travaux portant sur la recherche de nouvelles technologies ultrarapides à faible consommation ont prouvé que le transistor à effet de champ à barrière Schottky en arséniure de gallium constitue un composant de commutation à grande vitesse qui peut être intégré monolithiquement avec des résistances et des diodes Schottky pour former des circuits logiques ultrarapides ou des circuits hyperfréquences. Ces performances sont dues aux propriétés de l'arséniure de gallium, qui présente une mobilité électronique et une vitesse de saturation élevée.

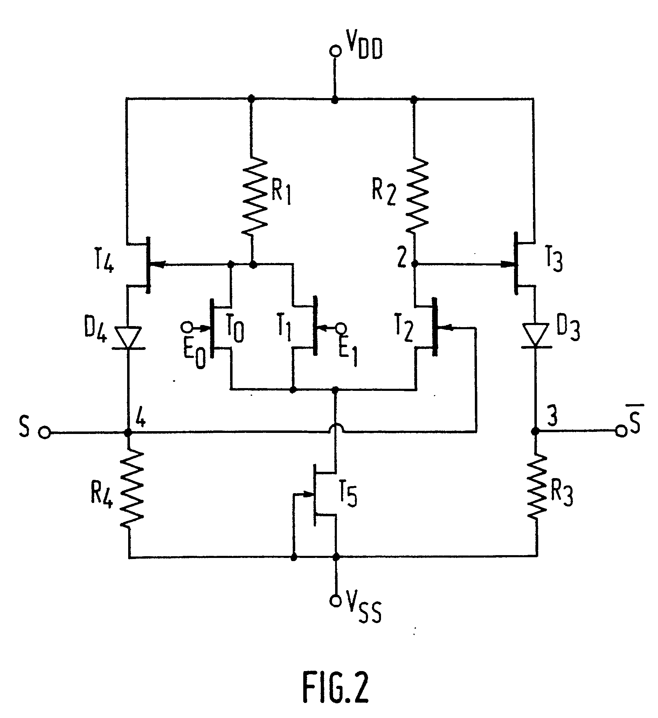

Une porte logique telle que décrite dans le préambule est connue de l'art antérieur par la publication de Katsushiko Suyama et alii, de FUJITSU Ltd, intitulée "A GaAs high-speed counter using current mode logic" dans MCS 83 (Microwave and Millimeterwave Monolithic Circuit Symposium, IEEE 1983) pages 12 et suivantes. Cette publication décrit un circuit numérique ultrarapide en GaAs utilisé pour applications hyperfréquences. Ce circuit est réalisé à partir d'une porte logique élémentaire en technologie CML (de l'anglais : Current Mode Logic) illustrée par la figure 2 du document cité. Cette porte logique est constituée d'un amplificateur différentiel et de deux étages dits BUFFER appariés. l'amplificateur différentiel comprend deux transistors à effet de champ normalement passants de tension de seuil -0,4 V dits DRIVER,

2

EP 0 153 774 B1

commandés l'un par la tension d'entrée (INPUT), l'autre par un signal de référence (REF). Les sources couplées de ces deux transistors sont reliées au drain d'un transistor à effet de champ normalement passant, mais de tension de seuil différente -0,8 V, dont la grille et la source court-circuitées sont reliées à la tension d'alimentation $V_{SS}$(-5V) de telle sorte que ce transistor fonctionne en source de courant. Les drains des transistors DRIVER sont reliés à la tension d'alimentation $V_{DD}$ = 0V (la masse) à travers deux résistances de charge $R_L$. La tension de ces drains vient commander les grilles respectives des transistors à effet de champ normalement passants de tension de seuil -0,8V des étages BUFFER. Ces derniers transistors sont montés en drain commun à la tension $V_{DD}$ = 0, et leur source est reliée à deux diodes montées en série et reliées à un transistor constituant une source de courant analogue à celle de l'étage différentiel. Les sorties de la porte logique se font sur les drains des transistors sources de courant des BUFFERS, sous la forme du signal d'entrée amplifié par l'un et de son complémentaire pour l'autre.

Ce circuit fonctionne à l'aide d'une seule tension d'alimentation $V_{SS}$ = -5V puisque la seconde $V_{DD}$ = 0 est la masse, et le signal REF est une référence interne. La tension d'alimentation supplémentaire qui était référencée $V_B$ et qui commandait les transistors source de courant dans la description de la cellule ECL du brevet français n° 78 30 358, n existe pas dans le présent circuit du fait que la grille de chacun des trois transistors sources de courant est court-circuitée avec la source et portée au potentiel $V_{SS}$ = -5V.

Ce circuit est en outre complètement compatible avec la logique ECL réalisée sur silicium.

Cependant le fait que ce circuit fait appel, pour commander le second transistor de l'étage différentiel, à un signal de référence REF entraîne certains inconvénients. Le premier inconvénient réside dans le fait que ce signal doit être fabriqué sur le même substrat que le circuit à proximité de ce dernier, ce qui diminue la densité d'intégration et augmente la consommation du circuit. Mais l'inconvénient le plus important est que l'emploi d'un tel signal comme référence diminue sensiblement la dynamique de réponse du circuit logique élémentaire.

C'est pourquoi la présente invention apporte une amélioration notable dans la réalisation d'un circuit élémentaire tel que défini dans le préambule en proposant un tel circuit remarquable en ce que la sortie $S_1$ de la première branche de l'amplificateur différentiel est couplée à l'entrée de la seconde branche par l'intermédiaire de l'étage translateur du niveau de cette sortie $S_1$, pour appliquer sur l'entrée de la seconde branche un signal de référence formé du signal de sortie S du circuit logique qui est complémentaire du signal d'entrée E de la première branche.

D'autres inconvénients non négligeables résident dans l'emploi de transistors à désertion de charge dans l'amplificateur différentiel et dans les étages translateurs de niveau, dans la réalisation de trois sources de courant pour la seule porte élémentaire, ainsi que dans l'emploi de deux diodes par étage translateur ce qui augmente considérablement la consommation d'un tel circuit.

Ces problèmes sont résolus par un tel circuit, caractérisé en ce que les première et seconde branches de l'amplificateur différentiel comprennent respectivement les transistors $T_1$, $T_2$ polarisés par une première tension $V_{DD}$ respectivement à travers des charges résistives $R_1$, $R_2$, en ce que ces branches couplées sont alimentées en courant par un transistor $T_5$ relié à une seconde tension $V_{SS}$, le transistor $T_1$ de la première branche étant commandé par le signal d'entrée E.

Ces problèmes sont aussi résolus par un tel circuit caractérisé, en outre, en ce que les étages translateurs de niveau comprennent des transistors respectivement $T_4$, $T_3$ polarisés directement par la première tension $V_{DD}$ et reliés d'autre part à la seconde tension $V_{SS}$ à travers une diode, respectivement $D_4$, $D_3$, en série avec une résistance respectivement $R_4$, $R_3$, les sorties S et $\overline{S}$ du circuit logique étant disponibles au point commun de la diode et de la résistance, respectivement $D_4$, $R_4$ et $D_3$, $R_3$.

Ces problèmes sont aussi résolus par un tel circuit caractérisé en ce que les transistor $T_1$, $T_2$, $T_4$, $T_3$ inclus dans les branches de l'amplificateur différentiel et les translateurs de niveau sont des transistors à effet de champ (FET) à enrichissement, et en ce que le transistor source de courant $T_5$ de l'amplificateur différentiel est un transistor à effet de champ (FET) à désertion dont les grille et source court-circuitées sont reliées à la seconde tension $V_{SS}$.

Il peut être également réalisé à partir d'un tel circuit élémentaire un circuit remarquable en ce que la première branche de l'amplificateur différentiel comprend un autre transistor $T_6$ disposé en parallèle sur le premier transistor $T_1$, et commandé par un second signal d'entrée $E_0$ pour fournir un signal de sortie S du circuit logique résultat de l'opération logique NON-OU entre les signaux d'entrée $E_1$ et $E_0$, ce signal étant appliqué sur l'entrée de la seconde branche de l'amplificateur différentiel pour servir de référence.

Dans ces conditions le circuit élémentaire ainsi que les autres circuits réalisés à partir de ce dernier sont parfaitement compatibles avec la logique ECL, lorsque, pour le rendre compatible avec les circuits de technologie dite ECL 100 K, la première tension d'alimentation $V_{DD}$ est de valeur 0 V, la seconde tension d'alimentation $V_{SS}$ est de valeur -4,5 V, la tension de seuil des transistors normalement pincés est 0 V et celle du transistor normalement passant est -1,5 V.

3

En comparaison avec l'art antérieur, la consommation est fortement diminuée, la fonction de transfert est améliorée, l'hystérésie est diminuée ainsi que le temps de propagation. De plus la suppression de l'obligation de fabriquer la tension de référence interne, ainsi que celle de quatre éléments actifs par cellule procure au niveau de la densité d'intégration et de la facilité de réalisation du circuit intégré un avantage certain.

La description ci-après, en se référant aux figures annexées fera mieux comprendre comment l'invention est réalisée.

La figure 1 représente le circuit élémentaire à une entrée et à deux sorties complémentaires à fonction de simple inverseur.

La figure 2 représente le circuit élémentaire à deux entrées et à deux sorties complémentaires, à fonction logique NON-OU/OU.

La figure 3 représente la courbe de transfert du circuit logique élémentaire à fonction simple inverseur.

Le circuit logique élémentaire selon la présente invention est constitué de diodes et de transistors à effet de champ de type Schottky monolithiquement intégrés avec des résistances sur un substrat en arséniure de gallium.

Il est destiné à composer des modules de circuits intégrés compatibles avec la logique ECL 100 K réalisée sur silicium. Il accepte donc les mêmes tensions d'alimentation :

$V_{DD} = 0$, la masse

et

$V_{SS} = -4,5$ V

Il reçoit en outre un signal d'entrée E dont les niveaux 0 et 1 sont respectivement de l'ordre de -0,9 V et -1,7 V identiques à ceux qui constituent les signaux d'entrée d'un circuit ECL.

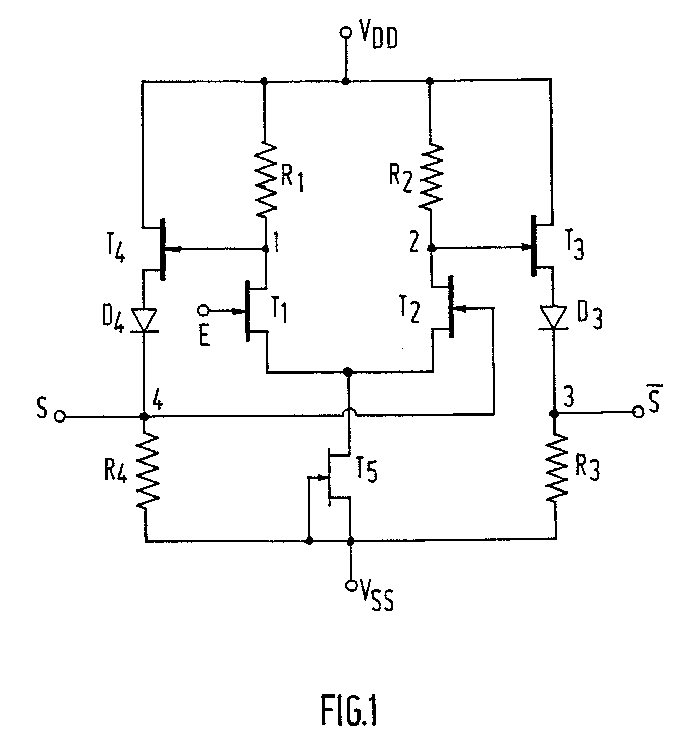

Tel que représenté sur la figure 1, le circuit élémentaire présente la fonction d'un simple inverseur, mais fournit deux sorties complémentaires. On dispose donc en sortie d'une part du signal $S = \bar{E}$ et d'autre part du signal $\bar{S} = E$.

Ce circuit élémentaire comprend d'abord un amplificateur différentiel, dont la première branche est constituée du transistor $T_1$, à enrichissement, et dont la seconde branche est constituée du transistor $T_2$ apparié avec ce dernier. Les drains des transistors $T_1$ et $T_2$ sont polarisés par la tension d'alimentation $V_{DD}$ = 0 à travers les résistances de charge respectives $R_1$ et $R_2$ appariées. Les sources des transistors $T_1$ et $T_2$ sont couplées et reliées au drain du transistor $T_5$ à désertion de charges. Celui-ci, dont la grille et la source court-circuitées sont portées au potentiel d'alimentation $V_{SS}$ = -4,5 V, fonctionne en source de courant.

Le transistor $T_1$ est commandé par le signal d'entrée E. La première branche de l'amplificateur différentiel fournit, sur le drain du transistor $T_1$, un signal $S_1$, alors que la seconde branche fournit sur le drain du transistor $T_2$ un signal $S_2$.

Ce circuit élémentaire comporte en outre deux étages translateurs de niveaux. Le premier de ces étages est constitué d'un transistor à enrichissement $T_4$ dont le drain est porté au potentiel d'alimentation $V_{DD}$ et dont la source est reliée à l'anode d'une diode $D_4$. Ce transistor $T_4$ est commandé par la sortie $S_1$ de la première branche de l'amplificateur différentiel et fonctionne en suiveur. La translation de niveau proprement dite est assurée par la diode $D_4$ de type Schottky. La cathode de cette diode est polarisée par la tension d'alimentation $V_{SS}$ à travers une résistance $R_4$.

La sortie du circuit élémentaire $S = \bar{E}$ est disponible sur la source du transistor $T_4$.

La caractéristique la plus importante de la présente invention est que ce signal S vient commander le transistor $T_2$ de la seconde branche de l'amplificateur différentiel et tient lieu de tension de référence pour le fonctionnement de cet étage différentiel.

Le second étage translateur de niveau est composé du transistor $T_3$, de la diode $D_3$ et de la résistance $R_3$ respectivement d'une part appariés avec le transistor $T_4$, la diode $D_4$ et la résistance $R_4$ du premier étage et d'autre part montés de façon identique.

Dans ces conditions la sortie $\bar{S} = E$ est disponible sur la source du transistor $T_3$.

Tel que représenté sur la figure 2, le circuit selon la présente invention peut présenter la fonction NON-OU/OU. Ainsi le transistor $T_1$ commandé par l'entrée E tel qu'il était représenté sur la figure 1, est remplacé par deux transistors identiques $T_0$ et $T_1$, commandés respectivement par les entrées $E_0$ et $E_1$ sur lesquelles est effectuée l'opération logique en sorte que les sorties de ce nouveau circuit élémentaire sont :

$S = \overline{E_0 + E_1}$

alors que

$$\overline{S} = E_0 + E_1$$

Les caractéristique des éléments actifs et passifs permettant de réaliser ce circuit en technologie auto-alignée sur arséniure de gallium sont les suivantes :

| Transistors | $T_1$, $T_2$ transistor à enrichissement | $T_3$, $T_4$ transistor à enrichissement | $T_5$ transistor à désertion | $D_3$, $D_4$ diode |
|---|---|---|---|---|
| Longueur de grille $L_G$ | 0,9 µm | 0,9 µm | | |
| Largeur de grille $\ell_G$ | 20 µm | 160 µm | 4,5 µm | 10 µm |
| Tension de pincement | 0 V | 0 V | -1,5 V | . |

| Résistances linéaires | $R_1$, $R_2$ | $R_3$, $R_4$ |
|---|---|---|
| | 1,9 k Ω | 10 k Ω |

Dans ces conditions ce circuit élémentaire présente de nombreux avantages.

En premier lieu, les niveaux d'entrée ne sont pas dégradés lorsque l'entrance du circuit est de deux, ce qui est le cas lorsque le circuit présente la fonction NON-OU.

En second lieu ces niveaux ne sont pas dégradés lorsque la sortance varie de 1 à 4.

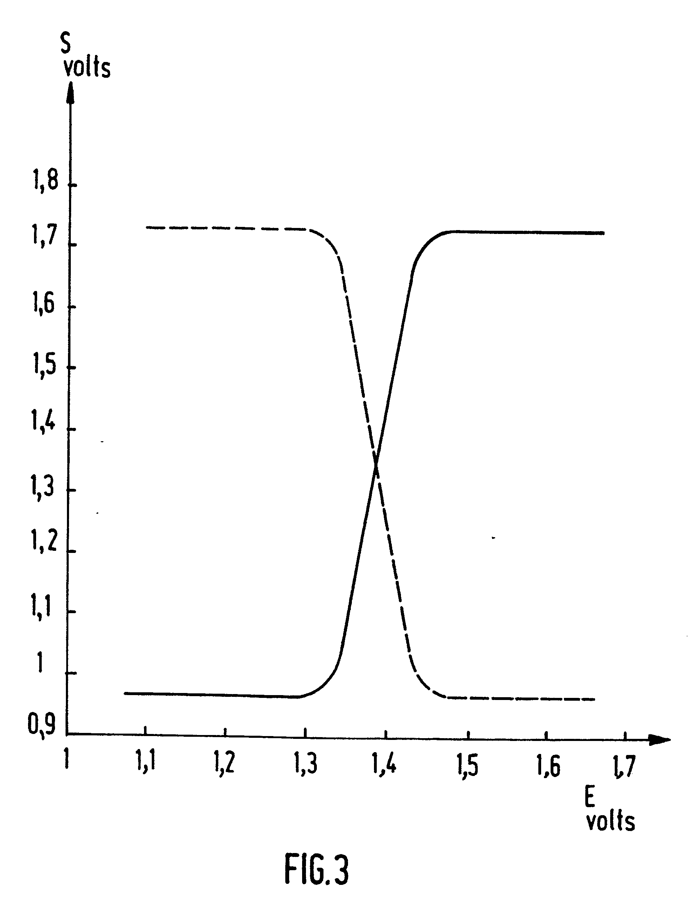

En troisième lieu le gain G de ce circuit, défini comme la pente de la courbe de transfert représentée sur la figure 3, c'est-à-dire

$$G = \frac{\Delta V_S}{\Delta V_E},$$

devient équivalent à 30, alors que ce même gain ne dépassait jamais la valeur 5 en technologie ECL 100 K. On constate en effet en considérant cette courbe que le passage du niveau bas au niveau haut se fait lorsque la tension d'entrée passe de 1,3 à 1,440 V. Ce qui produit une transition très abrupte.

En quatrième lieu, l'hystérésis est négligeable, de l'ordre d'une dizaine de millivolts, alors que l'excursion du cycle logique est de 0,8 V, l'excursion étant égale à la différence entre le niveau haut à -1,7 V et le niveau bas à -0,9 V. Il est à noter que ce comportement n'est pas obtenu en logique ECL. Dans le circuit selon la présente invention, la valeur de chacun des composants est rendue optimale de manière à réduire l'hystérésis tout en conservant les niveaux logiques requis. Ces résultats sont illustrés par les courbes représentées sur la figure 3, ces courbes montrant l'absolue symétrie de la fonction de transfert correspondant à ce circuit.

En cinquième lieu, l'utilisation des résistances $R_3$ et $R_4$ pour polariser les diodes $D_3$ et $D_4$, permet de réduire considérablement la consommation du circuit, par rapport au circuit réalisé en ECL d'une part, mais également par rapport au circuit décrit dans la publication japonaise citée comme art antérieur. En logique ECL la puissance consommée était de l'ordre de 25 mW. Elle est ici P≈4,7 mW pour une sortance égale à 1.

En sixième lieu, la suppression de la tension de référence interne venant commander le transistor de la seconde branche de l'amplificateur différentiel et son remplacement par une contre-réaction positive à l'aide du signal de sortie, permet d'une part d'augmenter la densité d'intégration et permet d'autre part de diminuer considérablement le temps de propagation, aussi bien par rapport au circuit ECL que par rapport au circuit cité comme art antérieur. Ce temps de propagation était de l'ordre de 400 ps en ECL, il est ici :

pour une sortance 1 : tpd ≃ 135 ps

pour une sortance 4 : tpd ≃170 ps.

On notera que le transistor $T_5$ assure la stabilité des niveaux de sortie en fonction des variations de la tension d'entrée de part et d'autre du seuil.

Il est manifeste que de nombreuses variantes à la présente invention sont possibles, en particulier dans le choix du substrat semi-isolant, ainsi que dans les dimensions et le choix de la technologie de réalisation des éléments actifs et passifs, sans pour autant sortir du cadre de la présente invention tel que défini par les revendications ci-après annexées.

## Revendications

1. Circuit logique réalisé avec des transistors unipolaires en arséniure de gallium (GaAs), comprenant un amplificateur différentiel et des étages translateurs de niveau appliqués respectivement aux sorties ($S_1$ et $S_2$) de la première et de la seconde branches de l'amplificateur différentiel, étages translateurs fournissant les sorties (S et $\overline{S}$) du circuit logique,
caractérisé en ce que la sortie ($S_1$) de la première branche de l'amplificateur différentiel est couplée à l'entrée de la seconde branche par l'intermédiaire de l'étage translateur du niveau de cette sortie ($S_1$), pour appliquer sur l'entrée de la seconde branche un signal de référence formé du signal de sortie (S) du circuit logique qui est complémentaire du signal d'entrée (E) de la première branche.

2. Circuit selon la revendication 1, caractérisé en ce que les première et seconde branches de l'amplificateur différentiel comprennent respectivement les transistors ($T_1$, $T_2$) polarisés par une première tension ($V_{DD}$) respectivement à travers des charges résistives ($R_1$, $R_2$) en ce que ces branches couplées sont alimentées en courant par un transistor ($T_5$) relié à une seconde tension ($V_{SS}$), le transistor ($T_1$) de la première branche étant commandé par le signal d'entrée (E).

3. Circuit selon la revendication 2, caractérisé en ce que les étages translateurs de niveau comprennent des transistors respectivement ($T_4$, $T_3$) polarisés directement par la première tension ($V_{DD}$) et reliés d'autre part à la seconde tension ($V_{SS}$) à travers une diode, respectivement ($D_4$, $D_3$,) en série avec une résistance respectivement ($R_4$, $R_3$) les sorties (S) et ($\overline{S}$) du circuit logique étant disponibles au point commun de la diode et de la résistance, respectivement ($D_4$, $R_4$ et $D_3$, $R_3$).

4. Circuit selon la revendication 3, caractérisé en ce que les transistor ($T_1$, $T_2$, $T_4$, $T_3$) inclus dans les branches de l'amplificateur différentiel et les translateurs de niveau sont des transistors à effet de champ (FET) à enrichissement, et en ce que le transistor source de courant ($T_5$) de l'amplificateur différentiel est un transistor à effet de champ (FET) à désertion dont les grille et source court-circuitées sont reliées à la seconde tension ($V_{SS}$).

5. Circuit selon l'une des revendications 2 à 4, caractérisé en ce que la première branche de l'amplificateur différentiel comprend un autre transistor ($T_6$) disposé en parallèle sur le premier transistor ($T_1$), et commandé par un second signal d'entrée ($E_0$) pour fournir un signal de sortie (S) du circuit logique résultat de l'opération logique NON-OU entre les signaux d'entrée ($E_1$ et $E_0$), ce signal étant appliqué sur l'entrée de la seconde branche de l'amplificateur différentiel pour servir de référence.

6. Circuit selon l'une des revendications 2 à 5, caractérisé en ce que, pour le rendre compatible avec les circuits de technologie dite ECL 100 K, la première tension d'alimentation ($V_{DD}$) est de valeur 0 V, la seconde tension d'alimentation ($V_{SS}$) est de valeur -4,5 V, la tension de seuil des transistors normalement pincés est 0 V et celle du transistor normalement passant est -1,5 V.

## Claims

1. A logic circuit realized by means of unipolar gallium arsenide (GaAs) transistors, comprising a differential amplifier and level translator stages which act on the outputs ($S_1$ and $S_2$) of the first and the second branch of the differential amplifier and which supply the output signals (S and $\overline{S}$) of the logic circuit, characterized in that the output ($S_1$) of the first branch of the differential amplifier is coupled to the input of the second branch, via the level translator stage of this output ($S_1$), in order to supply the input of the second branch with a reference signal which is formed from the output signal (S) of the logic circuit and whch is the complement of the input signal (E) of the first branch.

2. A circuit as claimed in Claim 1, characterized in that the first and the second branch of the differential amplifier comprise the transistors ($T_1$, $T_2$), respectively, which are biased by a first voltage ($V_{DD}$) via resistive loads ($R_1$, $R_2$), respectively, in that these coupled branches receive a current from a transistor ($T_5$) which is connected to a second voltage ($V_{SS}$), the transistor ($T_1$) of the first branch being controlled by the input signal (E).

3. A circuit as claimed in Claim 2, characterized in that the level translator stages comprise transistors ($T_4$, $T_3$), respectively, which are biased directly by the first voltage ($V_{DD}$) and which are connected to the second voltage ($V_{SS}$) via a diode ($D_4$, $D_3$), respectively, in series with a resistance ($R_4$, $R_3$), respectively, the output signals (S) and ($\overline{S}$) of the logic circuit being available at the common juncion of the diode and the resistance ($D_4$, $R_4$ and $D_3$, $R_3$), respectively.

4. A circuit as claimed in Claim 3, characterized in that the transistors ($T_1$, $T_2$, $T_3$, $T_4$) included in the branches of the differential amplifier and the level translator stages are enhancement-type field effect transistors (FET), and in that the current source transistor ($T_5$) of the differential amplifier is a depletion-type field effect transistor (FET) whose shortcircuited gate and source are connected to the second voltage ($V_{SS}$).

5. A circuit as claimed in one of the Claims 2 to 4, characterized in that the first branch of the differential amplifier comprises another transistor ($T_6$) which is connected parallel to the first transistor ($T_1$) and which is controlled by a second input signal ($E_0$) in order to supply an output signal (S) of the logic circuit which is the result of a logic NOR operation between the input signals ($E_1$ and $E_0$), said signal being applied to the input of the second branch of the differential amplifier in order to serve as a reference.

6. A circuit as claimed in one of the Claims 2 to 5, characterized in that, in order to make the circuit compatible with the circuits in ECL 100 K technology, the first supply voltage ($V_{DD}$) is 0 V, the second supply voltage ($V_{SS}$) is -4.5 V, the threshold voltage of the normally pinched transistors is 0 V and that of the transistor normally connected in the forward direction is -1.5 V.

**Patentansprüche**

1. Logische Schaltung, bestehend aus einpoligen Transistoren aus Galliumarsenid (GaAs), mit einem Differenzverstärker und Pegelübersetzungsstufen, die an die Ausgänge ($S_1$ und $S_2$) des ersten und des zweiten Abzweigs des Differenzverstärkers angeschlossen sind, wobei die Übersetzungsstufen die Ausgangssignale (S und $\overline{S}$) der logischen Schaltung liefern, dadurch gekennzeichnet, daß der Ausgang ($S_1$) des ersten Abzweigs des Differenzverstärkers mit dem Eingang des zweiten Abzweigs über die Pegelübersetzungsstufe dieses Ausgangs ($S_1$) verbunden ist, um den Eingang des zweiten Abzweigs mit einem Bezugssignal zu beliefern, das aus dem Ausgangssignal des Ausgangs (S) der logischen Schaltung gebildet wird und mit dem Eingangssignal (E) des ersten Abzweigs komplementär ist.

2. Schaltung nach Anspruch 1, dadurch gekennzeichnet, daß die ersten und zweiten Abzweige des Differenzverstärkers die Transistoren ($T_1$ bzw. $T_2$) enthalten, die durch eine erste Spannung ($V_{DD}$) jeweils über Widerstandsbelastungen ($R_1$ bzw. $R_2$) polarisiert sind, daß diese gekoppelten Abzweige durch einen Transistor ($T_5$) mit Strom beliefert wird, der mit einer zweiten Spannung ($V_{SS}$) verbunden ist, wobei der Transistor ($T_1$) des ersten Abzweigs durch das Eingangssignal (E) gesteuert wird.

3. Schaltung nach Anspruch 2, dadurch gekennzeichnet, daß die Pegelübersetzungsstufen Transistoren ($T_4$ bzw. $T_3$) enthalten, die direkt durch die erste Spannung ($V_{DD}$) polarisiert und andererseits mit der zweiten Spannung ($V_{SS}$) über eine Diode (D4 bzw. $D_3$) in Reihe mit einem Widerstand ($R_4$ bzw. $R_3$) gekoppeld sind, wobei die 4usgänge (S) und ($\overline{S}$) der logischen Schaltung an dem gemeinsamen Punkt der Diode und des Widerstands verfügbar sind ($D_4$, $R_4$ bzw. $D_3$, $R_3$).

4. Schaltung nach Anspruch 3, dadurch gekennzeichnet, daß die Transistoren ($T_1$, $T_2$, $T_4$, $T_3$) in den Abzweigen des Differenzverstärkers und in den Pegelübersetzern Enhancement-Feldeffekttransistoren

EP 0 153 774 B1

(FET) sind, und daß der Stromquellentransistor (T$_5$) des Differenzverstärkers ein Depletion-Feldeffekttransistor (FET) ist, dessen kurzgeschlossenes Gate und kurzgeschlossene Source mit der zweiten Spannung (V$_{SS}$) verbunden sind.

5. Schaltung nach einem der Ansprüche 2 bis 4, dadurch gekennzeichnet, daß der erste Abzweig des Differenzverstärkers einen weiteren Transistor ($\overline{T_6}$) enthält, der parallel zum ersten Transistor (T$_1$) angebracht ist, und durch ein zweites Eingangssignal (E$_0$) zum Ausliefern eines Ausgangssignals (S) der logischen Schaltung als Ergebnis der logischen Operation NICHT-ODER zwischen den Eingangssignalen (E$_1$ und E$_0$) gesteuert wird, wobei dieses Signal dem Eingang des zweiten Abzweigs des Differenzverstärkers als Bezugssignal zugeleitet wird.

6. Schaltung nach einem der Ansprüche 2 bis 5, dadurch gekennzeichnet, daß zur Kompatibilisierung dieser Schaltung mit den technologischen Schaltungen vom Typ ECL 100 K die erste Speisespannung (V$_{DD}$) den Wert 0 Volt, die zweite Speisespannung (V$_{SS}$) den Wert -4,5 Volt hat, die Schwellenspannung der Transistoren normalerweise auf 0 Volt geklemmt ist und die Schwellenspannung des normalerweise durchlässigen Transistors -1,5 Volt beträgt.

8

FIG.1

FIG.2

FIG.3